# EUROPÄISCHE PATENTSCHRIFT

(11) **EP 1 803 964 B1**
(45) Veröffentlichungstag und Bekanntmachung des Hinweises auf die Patenterteilung: **20.04.2016**
(21) Anmeldenummer: 06009025.5
(22) Anmeldetag: 02.05.2006
(51) Int. Cl.: F16F 15/023, G03F 7/20, F16C 32/06

(54) **Lager zur Schwingungsisolation mit verringerter horizontaler Steifigkeit**
Hybrid stiffness module for vibration isolation
Module hybride de rigidité pour isolation de vibrations

(30) Priorität: 30.12.2005 EP 05028716
(43) Veröffentlichungstag der Anmeldung: 04.07.2007
(73) Patentinhaber: Integrated Dynamics Engineering GmbH, 65479 Raunheim (DE)
(72) Erfinder: Heiland, Peter, 65479 Raunheim (DE)
(74) Vertreter: Blumbach Zinngrebe

(56) Entgegenhaltungen:
- EP-A- 0 973 067
- EP-A- 1 744 215
- EP-A- 1 803 963
- EP-B1- 0 927 380
- WO-A-96/19682
- BE-A- 476 448
- DE-A1- 19 606 994
- DE-A1-102004 032 411
- US-A1- 2004 080 729
- US-A1- 2004 084 824

## Beschreibung

### Gebiet der Erfindung

Die Erfindung betrifft ein Lager zur Schwingungsisolation, sowie ein Schwingungsisolationssystem und ein Verfahren zur Schwingungsisolation, bei welchem zumindest ein Fluidlager Teil eines Lagers zur Schwingungsisolation ist.

### Hintergrund der Erfindung

Schwingungsisolationssysteme sind bekannt. So zeigt beispielsweise die EP 927 380 B1 ein vertikal und horizontal wirksames Luftlager, mit welchem insbesondere ein Schwingungsisolationssystem zur Lagerung eines Litographiegerätes bereitgestellt werden kann. Es handelt sich bei diesem horizontal und vertikal wirksamen Luftlager um ein offenes System, das heißt es strömt kontinuierlich Druckluft durch das Lager, so dass die zu lagernde Last berührungslos von der Basis abgekoppelt ist. Derartige Luftlager haben den Nachteil eines hohen Luftverbrauchs und sind empfindlich gegenüber Schwankungen des Versorgungsluftdruckes. Darüber hinaus unterliegen derartige Lager einem Eigenrauschen, welches dazu führt, dass eine Isolierung gegen kleine niederfrequente Schwingungsamplituden nur bedingt möglich ist. Darüber hinaus haben derartige Lager konstruktionsbedingt eine wesentlich höhere Steifigkeit in horizontaler Richtung. Ein derartiges Lager ist daher auch zur Isolation von Schwingungen, welche eine horizontale Komponente aufweisen, nicht besonders gut geeignet.

US 2004 084824 offenbart ein in horizontaler und vertikaler Richtung wirksames Luftlager zur horizontalen und vertikalen Lagerung einer zu isolierenden Last, mit einem oberen Drehgelenk. US 2004 080729 offenbart ein Lager zum Schwingungsisolation, mit Luftisolator und Luftlager.

In der Halbleiterindustrie steigen mit der Miniaturisierung von Bauelementen immer mehr die Anforderungen an derartige Schwingungsisolationssysteme. Aufgrund von auf dem Schwingungsisolationssystem angeordneten beweglichen Maschinenelementen, wie Robotern zur Fertigung von Halbleiterbauelementen, treten vermehrt Schwingungen auf, welche hohe horizontale Kraftkomponenten aufweisen.

Weiter sind aus der Praxis Luftlager bekannt, welche geschlossen sind, beispielsweise ausgestaltet als mit Druckluft gefüllter Faltenbalg. Derartige Lager eignen sich aufgrund der dadurch resultierenden mechanischen Verbindung von Basis und zu lagernder Last nicht für niederfrequente Schwingungsamplituden.

### Aufgabe der Erfindung

Der Erfindung liegt demgegenüber die Aufgabe zugrunde, ein Lager zur Schwingungsisolation sowie ein Verfahren zur Schwingungsisolation bereitzustellen, welches die vorstehend genannten Nachteile des Standes der Technik mindert.

Insbesondere ist Aufgabe der Erfindung, ein Lager zur Schwingungsisolation bereitzustellen, welches die horizontale Steifigkeit des Lagers, insbesondere im niederfrequenten Bereich verringert und so auch eine wirkungsvolle Isolation gegen niederfrequente Schwingungen mit kleiner Schwingungsamplitude ermöglicht.

Eine weitere Aufgabe der Erfindung ist es, ein Luftlager bereitzustellen, welches bei gleich guter oder sogar verbesserter Isolationswirkung mit einem geringeren Luftverbrauch auskommt.

### Zusammenfassung der Erfindung

Die Aufgabe der Erfindung wird bereits durch ein Lager zur Schwingungsisolation, ein Schwingungsisolationssystem sowie ein Verfahren zur Schwingungsisolation nach einem der unabhängigen Ansprüche erreicht.

Bevorzugte Ausführungsformen und Weiterbildungen der Erfindung sind den jeweiligen Unteransprüchen zu entnehmen.

Die Erfindung sieht ein Lager zur Schwingungs.isolation vor, welches zumindest ein Fluidlager, welches als Luftlager ausgestaltet ist, umfasst. Das Luftlager ist sowohl zur horizontalen als auch zur vertikalen Lagerung einer zu isolierenden Last ausgebildet, ist also sowohl in horizontaler als auch in vertikaler Richtung wirksam.

Neben dem Fluidlager umfasst das Lager zur Schwingungsisolation zumindest zwei vertikal voneinander beabstandete, insbesondere mechanisch arbeitende Drehgelenke. Durch diese Drehgelenke, welche vorzugsweise eine Federsteifigkeit aufweisen, also als Federdrehgeleke ausgestaltet sind, wird eine dem Luftlager hinzu addierte Isolierung in horizontaler Richtung erreicht. Die beiden Drehgelenke sind vorzugsweise wie ein Kugelgelenk bewegbar, so dass die zu isolierende Last sich bei gleichzeitiger Bewegung der Gelenke mit gleichem Winkel in horizontaler Richtung bewegen kann.

So kann die horizontale Isolierung im Wesentlichen von den beiden Drehgelenken übernommen werden.

Das Fluidlager hingegen besitzt eine horizontal Steifigkeit, welche mehr als 5, vorzugsweise mehr als 10 und besonders bevorzugt mehr als 15 mal so groß ist, wie die vertikale Steifigkeit. So können Fluidlager mit einer geringen horizontalen Steifigkeit verbaut werden. Die Dicke der Luftspalte kann so reduziert werden, wodurch der Luftverbrauch eines mit entsprechenden Lagern zur Schwingungsisolation versehenen Schwingungsisolationssystems gesenkt werden kann.

Bei einer bevorzugten Ausführungsform der Erfindung ist die vertikale Steifigkeit des Lagers mindestens 0,5, vorzugsweise 0,7 und besonders bevorzugt 0,9 mal so groß wie die horizontale Steifigkeit des Lagers.

Durch die Drehgelenke kann also ein Lager bereitgestellt werden, bei welchem die horizontale Steifigkeit ähnlich niedrig oder sogar niedriger ist, wie die vertikale Steifigkeit. Eine Isolation gegen Schwingungen mit horizontaler Kraftkomponente ist daher ohne wesentliche Einschränkungen möglich.

Die Drehgelenke sind bei einer bevorzugten Ausführungsform der Erfindung zumindest in den zwei
Rotationsfreiheitsgraden, welche im Wesentlichen senkrecht zu einer Vertikalachse verlaufen, beweglich. So wird die horizontale Steifigkeit des Lagers in allen Richtungen der Horizontalebene verbessert.

Bei einer Weiterbildung der Erfindung sind die Drehgelenke oberhalb und unterhalb des Fluidlagers angeordnet, beziehungsweise es befindet sich der Drehpunkt im Wesentlichen oberhalb und unterhalb des Fluidlagers. So wird eine besonders kompakte Bauform des Lagers ermöglicht, wobei das Fluidlager als den Abstand zwischen den beiden Drehgelenken definierender Hebel fungiert.

Bei einer Weiterbildung der Erfindung ist zumindest eines der Drehgelenke, vorzugsweise ein unteres Drehgelenk, als Faltenbalg, insbesondere als Metallfaltenbalg ausgebildet. Derartige Faltenbalge tragen neben einer Eigenschaft als Drehgelenk gleichzeitig zur Isolation bei und besitzen zugleich eine Federsteifigkeit, so dass auf weitere Federkomponenten zur Ausrichtung des Lagers verzichtet werden kann.

Sofern ein unteres Drehgelenk als Faltenbalg ausgebildet ist, kann die Fluidzufuhr über diesen Faltenbalg erfolgen, so dass der Faltenbalg zugleich Teil der Fluidzuführung ist.

Vorzugsweise werden Metallfaltenbalge verwendet, welche weniger dazu neigen, durch vorbeiströmende Luft zu Resonanzschwingungen angeregt zu werden. Das im System vorhandene Kraftrauschen wird so reduziert.

Bei einer weiteren bevorzugten Ausführungsform der Erfindung ist zumindest eines der Drehgelenke, insbesondere das obere Drehgelenk als Feder, insbesondere als Metallfeder ausgebildet.

Zur Bereitstellung von federnden Eigenschaften kann als Feder ein elastomeres Vollmaterial verwendet werden, insbesondere ein Gummiblock. Derartige Gummigelenke haben zwar den Nachteil, dass sich das elastomere Material bei Belastung und/oder im Laufe der Zeit setzt, sind aber eine preiswerte und zuverlässige Ausführungsvariante.

Bei einer Weiterbildung der Erfindung weist das Lager eine weitere Feder auf, insbesondere eine Blattfeder. Diese Blattfeder ist vorzugsweise so ausgebildet, dass die Steifigkeit senkrecht zur Achse des Lagers, also in horizontaler Richtung höher ist als die vertikale Steifigkeit. Insbesondere hat die Blattfeder eine horizontale Steifigkeit, die mindestens fünfmal höher als die vertikale Steifigkeit ist.

Über die Steifigkeit einer Blattfeder kann das Drehgelenk als Federgelenk ausgestaltet werden. Die geringe vertikale Steifigkeit der Feder minimiert dabei Einkopplungen von Schwingungen durch die Feder in das Schwingungsisolationssystem.

Bei einer Weiterbildung der Erfindung ist die horizontale Steifigkeit der weiteren Feder veränderbar und kann beispielsweise mechanisch oder über ein elektrisches oder pneumatisches Stellglied eingestellt werden. So kann ein Lager bereitgestellt werden, welches eine variable einstellbare horizontale Steifigkeit aufweist. Es ist dabei besonders von Vorteil, dass die horizontale Steifigkeit nicht über den Fluiddruck eingestellt werden muss. Eine erhöhte horizontale Steifigkeit führt daher nicht zu erhöhtem Luftverbrauch. Zudem hängen horizontale und vertikale Steifigkeit im Wesentlichen nicht voneinander ab.

Bei einer Weiterbildung der Erfindung ist eine vertikale Feder des Fluidlagers abgedichtet, insbesondere mittels einer elastomeren Haut oder einer Gummimembran. Es ist insbesondere vorgesehen, eine derartige Feder als Luftfeder auszugestalten. Aufgrund der Abdichtung handelt es sich dabei um ein geschlossenes System, wodurch der Luftverbrauch des Fluidlagers gesenkt wird.

Bei einer weiteren Ausführungsform des Drehgelenkes ist zumindest ein Drehgelenk, insbesondere das untere Drehgelenk als Knickpendelgelenk ausgestaltet. Derartige Knickpendel, welche auf Biegung belastet werden, ermöglichen ebenfalls die Ausgestaltung als Drehfederlager.

Bei einer Weiterbildung der Erfindung ist in dem Lager zumindest ein Aktor, insbesondere ein Piezoaktor oder Magnetaktor vorgesehen, welcher eine aktive Regelung des Lagers in zumindest einem Freiheitsgrad ermöglicht.

Ein derartiger Aktor greift vorzugsweise berührungslos an der zu lagernden Last an und es lassen sich mit dem Aktor Schwingungen aktiv eliminieren. Gleichzeitig kann die Aktorenregelung auch zur Änderung der Charakteristik des Lagers dienen, beispielsweise bei Belastungsänderungen des Schwingungsisolationssystems.

Bei einer weiteren Ausführungsform der Erfindung umfasst das Lager zumindest einen Sensor zur Messung von Positionsänderungen zwischen zu isolierenden Last, Basis und/oder einem Teil des Lagers. Über einen derartigen Sensor werden vorzugsweise berührungslos Positionsänderungen, insbesondere Schwingungen der zu isolierenden Last erfasst. Im Rahmen einer aktiven Regelung kann diesen Positionsänderungen über Aktoren oder über die Regelung des Fluiddrucks entgegengewirkt werden.

Die Erfindung betrifft des Weiteren ein Schwingungsisolationssystem, welches zumindest ein erfindungsgemäßes Lager zur Schwingungsisolation umfasst.

Bei einer bevorzugten Ausführungsform der Erfindung umfasst das Schwingungsisolationssystem des Weiteren einen Sensor zur Erfassung von Positionsänderungen der zu isolierenden Last in zumindest einer Raumrichtung. Dieser Sensor kann sowohl am Lager als auch an einer beliebigen Stelle der zu isolierenden Last angeordnet sein.

Vorzugsweise weist das Schwingungsisolationssystem eine Regelungseinrichtung auf, welche über eine aktive Steuerung Kompensationssignale generiert und so Aktoren oder das Fluidlager steuert.

Mit der Erfindung lassen sich effektive Schwingungsisolationssysteme mit hoher Tragfähigkeit bereitstellen, welche bis über 10 Tonnen betragen kann.

Des Weiteren betrifft die Erfindung ein Verfahren zur Schwingungsisolation, bei welchem insbesondere ein erfindungsgemäßes Lager zur Schwingungsisolation verwendet wird.

Bei dem Verfahren wird eine zu isolierende Last über zumindest ein Fluidlager gegen Schwingungen isoliert. Mittels zumindest zwei vertikal voneinander beabstandeten Drehgelenke erfolgt eine zusätzliche Schwingungsisolation zumindest in der Horizontalen.

Bei einer Weiterbildung der Erfindung wird die Absenkung der zu isolierenden Last, welche durch eine Bewegung der Drehgelenke in Folge einer horizontalen Verschiebung der zu isolierenden Last zwangsläufig verursacht wird, durch eine aktive Regelung automatisch kompensiert. Diese automatische Kompensation kann insbesondere über den Fluiddruck oder die Aktoren erfolgen.

Gemäß der Erfindung wird ein Lager bereitgestellt, bei welchem die horizontale Isolierung zumindest 60 %, bevorzugt 70 % und besonders bevorzugt 85 % über die Drehgelenke erfolgt.

### Kurzbeschreibung der Zeichnungen

Die Erfindung soll im Folgenden anhand der Zeichnungen Fig. 1 bis Fig. 6 näher erläutert werden.
- Fig. 1: zeigt eine schematische Ansicht einer Ausführungsform eines erfindungsgemäßen Lagers zur Schwingungsisolation,
- Fig. 2: zeigt schematisch eine weitere Ausführungsform, bei welcher eine Blattfeder in das Lager integriert ist,
- Fig. 3: zeigt schematisch eine weitere Ausführungsform, bei welcher ein Lager als Knickpendellager ausgestaltet ist,
- Fig. 4: zeigt eine weitere Ausführungsform eines Lagers zur Schwingungsisolation, bei welchem ein Gelenk als Knickpendelfedergelenk ausgestaltet ist,
- Fig. 5: zeigt schematisch eine perspektivische Ansicht eines Gummipuffers, welcher als Teil eines Drehgelenkes Verwendung findet,
- Fig. 6: zeigt schematisch eine Ausführungsform eines Schwingungsisolationssystems.

### Detaillierte Beschreibung der Zeichnungen

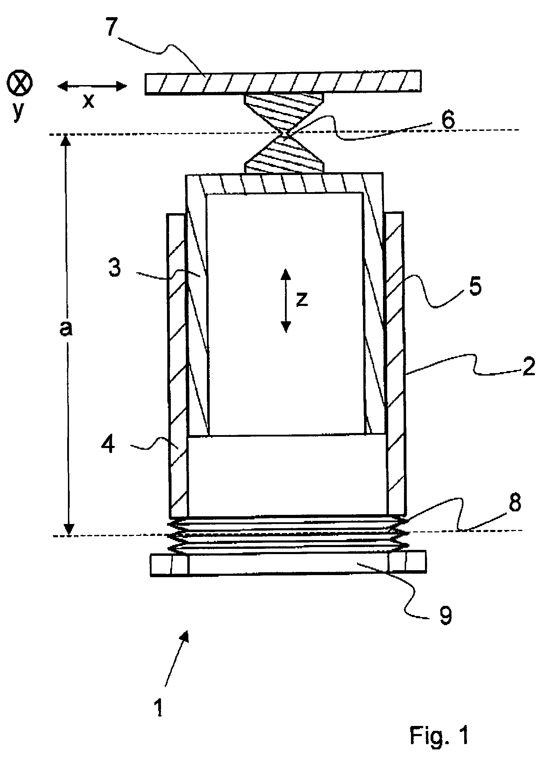

Bezug nehmend auf Fig. 1 wird schematisch eine Ausführungsform eines erfindungsgemäßen Lagers zur Schwingungsisolation 1 näher erläutert.

Das Lager zur Schwingungsisolation 1 umfasst als Fluidlager ein Luftlager 2, welches einen Kolben 3 umfasst, der in einem Zylinder 4 läuft.

Das Luftlager 2 ist als offenes Luftlager ausgestaltet: Im Betriebszustand bildet sich zwischen Kolben 3 und Zylinder 4 ein Luftspalt 5 aus, wodurch der Kolben 3 berührungslos im Zylinder 4 läuft.

Ein derartiges Luftlager 2 hat eine relativ niedrige Steifigkeit in vertikaler Richtung, also entlang der eingezeichneten Z-Achse.

Die Steifigkeit des Lagers in horizontaler, also senkrecht zur Z-Achse entlang der XY-Ebene, ist dagegen, insbesondere aufgrund der kleinen Luftspalte 5 relativ hoch.

Um ein derartiges Lager mit einer Steifigkeit bereitstellen zu können, welche auch in horizontaler Richtung gering ist, ist zwischen dem Luftlager 2 und der zu isolierenden Last 7 ein oberes Drehgelenk 6 sowie zwischen Luftlager 2 und Basisplatte 9 ein unteres Drehgelenk 8 vorgesehen. Die Relativbewegungen zwischen der zu isolierenden Last 7 und der Basisplatte 9 in einer horizontalen Richtung führen dazu, dass sich das obere Drehgelenk 6 und das untere Drehgelenk 8 bewegen. Die Bewegung muss also nicht von dem Luftlager 2 durch eine horizontale Bewegung des Kolbens 3 abgefangen werden.

Bei dem oberen Drehgelenk 6 handelt es sich bei diesem Ausführungsbeispiel um ein rein mechanisches Gelenk, während das untere Drehgelenk 8 als Federbalg ausgestaltet ist und über welches zugleich das Luftlager 2 mit Druckluft versorgt wird.

Oberes Drehgelenk 6 und unteres Drehgelenk 8 sind vertikal, also in Richtung der Z-Achse voneinander beabstandet, um eine geometrisch entgegengesetzte aber zeitgleiche Verdrehung durchzuführen. Da die Drehgelenke 6, 8 oberhalb und unterhalb des Luftlagers 2 angeordnet sind, wirkt das Luftlager 2 als Hebel zwischen den beiden Drehpunkten, deren Abstand durch a) bezeichnet ist. So ist die Bauhöhe des Lagers zur Schwingungsisolation 1 nicht wesentlich höher als bei einem reinen Luftlager.

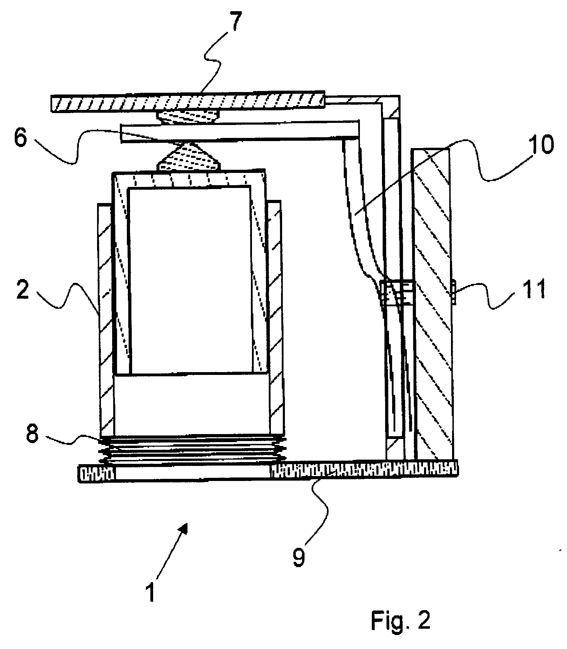

Bezug nehmend auf Fig. 2 soll eine weitere Ausführungsform der Erfindung näher erläutert werden. Das Lager zur Schwingungsisolation 1 gemäß Fig. 2 entspricht im Wesentlichen Fig. 1. Auch hier ist eine zu isolierende Last 7 auf einem Luftlager 2 gelagert. Es sind des Weiteren ein oberes Drehgelenk 6 und ein unteres Drehgelenk 8 vorgesehen, um eine horizontale Bewegung von Basis 9 und zu isolierender Last 7 gegeneinander zu ermöglichen.

Um das obere Drehgelenk 6 als Drehfedergelenk auszubilden, weist das Lager zur Schwingungsisolation 1 in dieser Ausführungsform eine Blattfeder 10 auf, welche eine hohe Steifigkeit in horizontaler Richtung, aber eine geringe Steifigkeit in vertikaler Richtung aufweist. Über ein Stellglied 11 kann zumindest die horizontale Steifigkeit der Blattfeder 10 eingestellt werden. Damit geht zugleich auch eine Veränderung der horizontalen Steifigkeit des gesamten Lagers einher. Das Lager zur Schwingungsisolation 1 kann so verschiedenen Betriebszuständen angepasst werden. Denkbar ist auch, das Stellglied 11 über eine Regelungseinrichtung (nicht dargestellt) anzusteuern und so das Lager zur Schwingungsisolation 1 automatisch veränderten Betriebsbedingungen anzupassen.

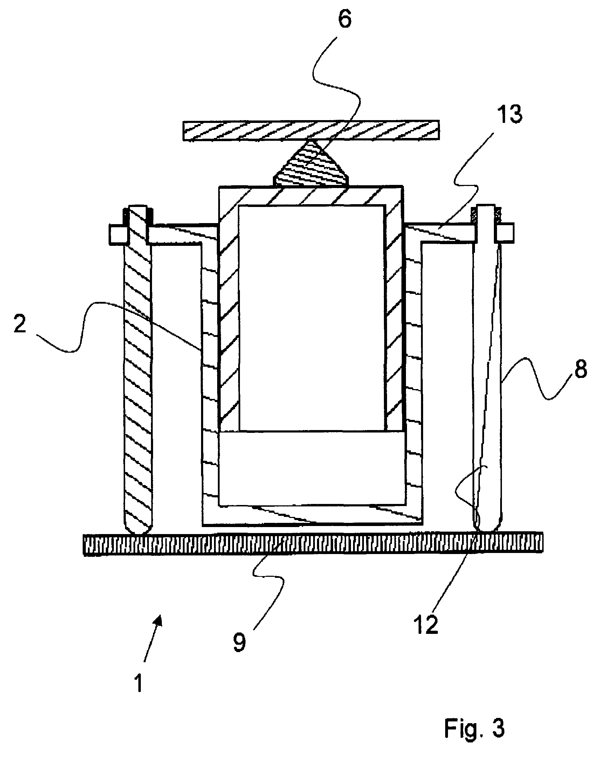

Bezug nehmend auf Fig. 3 soll eine weitere Ausführungsform der Erfindung näher erläutert werden, bei welcher das untere Drehgelenk 8 als Drehfedergelenk unter Verwendung von drei Knickpendeln 12 ausgestaltet ist. Die Knickpendel 12 sind mit dem Fluidlager über horizontale Querträger 13 verbunden und stützen sich auf der Basis 9 ab. Das obere Drehgelenk 6 ist nicht als Drehfederlager, sondern als rein mechanisches Lager ausgestaltet.

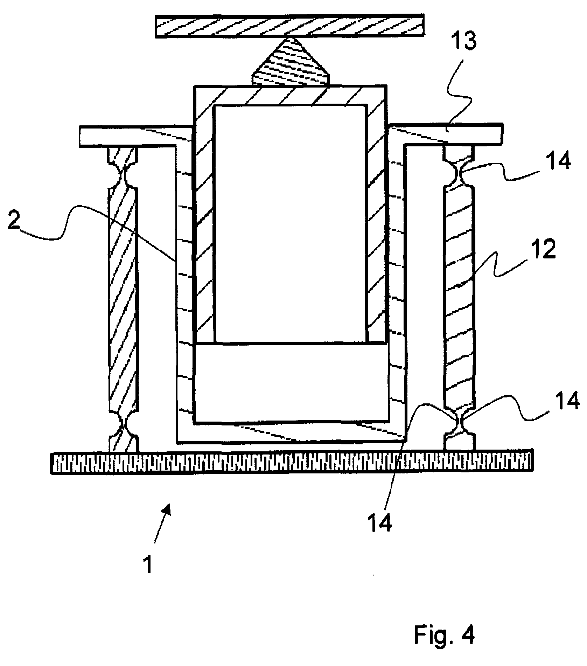

Eine weitere Ausführungsform der Erfindung ist in Fig. 4 dargestellt.

Hier sind die Knickpendel 12 als Festkörpergelenke ausgebildet, welche zur Erzielung einer geringeren Steifigkeit Aussparungen 14 aufweisen. Auch diese als Festkörpergelenke ausgestalteten Knickpendel 12 sind über einen Querträger mit dem Fluidlager 2 verbunden.

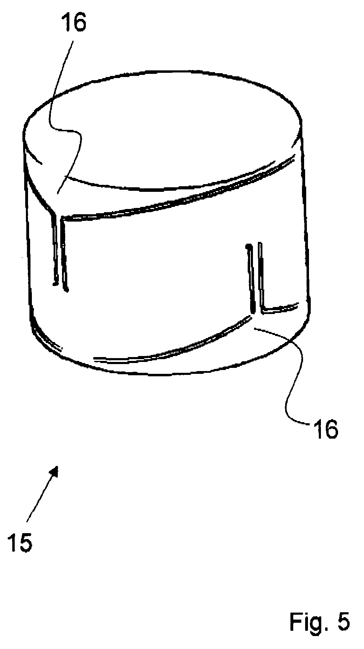

Fig. 5 zeigt eine schematische perspektivische Ansicht eines Gummipuffers 15, wie er Teil eines Drehfedergelenkes sein kann. Der Gummipuffer 15 ist im Wesentlichen aus Vollmaterial ausgestaltet und weist Aussparungen 16 auf, um beidseitig in einer Aufnahme (nicht dargestellt) gehalten werden zu können.

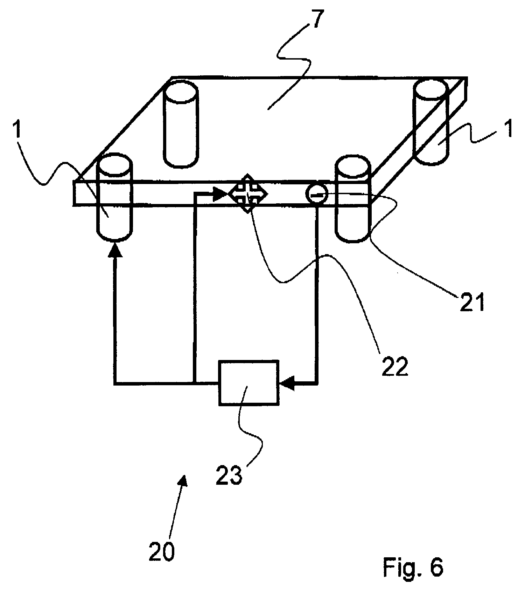

Bezug nehmend auf Fig. 6 sollen die wesentlichen Komponenten eines Ausführungsbeispiels eines Schwingungsisolationssystems 20 näher erläutert werden. Das Schwingungsisolationssystem 20 weist eine zu isolierende Last 7 auf, welche als Platte dargestellt ist und welche zur Aufnahme weiterer Bauelemente (nicht dargestellt), welche ebenfalls zur isolierenden Last gehören, ausgebildet ist.

Die zu isolierende 7 Last ist auf vier Lagern zur Schwingungsisolation 1 gelagert. Über einen Sensor 21 werden Positionsänderungen der zu isolierenden Last 7 berührungslos erfasst und das entsprechende Signal an eine Regeleinrichtung 23 weiter geregelt. Über die Regeleinrichtung 23 wird sowohl der Luftdruck der Lager 1 gesteuert, insbesondere um ein gleichbleibendes Niveau der zu isolierenden Last 7 bereitzustellen. Gleichzeitig steuert die Regeleinrichtung 23 einen Aktor 22 an, welcher berührungslos an der zu isolierenden Last 7 angreift und mit welchem insbesondere höherfrequenten Schwingungen in allen drei Raumrichtungen entgegengewirkt werden kann.

## Patentansprüche

1. Lager (1) zur Schwingungsisolation, umfassend zumindest ein in horizontaler und vertikaler Richtung wirksames Luftlager (2) zur horizontalen und vertikalen Lagerung einer zu isolierenden Last,
**dadurch gekennzeichnet, dass**
die horizontale Steifigkeit des Luftlagers (2) mehr als 5 mal höher ist als die vertikale Steifigkeit und dass das Lager (1) zumindest zwei vertikal voneinander beabstandete Drehgelenke (6, 8) aufweist, wodurch eine dem Luftlager (2) hinzu addierte Isolierung in horizontaler Richtung erreicht wird.

2. Lager zur Schwingungsisolation nach einem der vorstehenden Ansprüche, **dadurch gekennzeichnet, dass** zumindest ein Drehgelenk (6, 8) eine Federsteifigkeit aufweist.

3. Lager zur Schwingungsisolation nach einem der vorstehenden Ansprüche, **dadurch gekennzeichnet, dass** die horizontale Steifigkeit des Luftlagers (2) mehr als 10 und bevorzugt mehr als 15 mal höher ist als die vertikale Steifigkeit.

4. Lager zur Schwingungsisolation nach einem der vorstehenden Ansprüche, **dadurch gekennzeichnet, dass** die vertikale Steifigkeit des Lagers (1) mindestens 0,5, vorzugsweise 0,7 und besonders bevorzugt 0,9 mal so groß ist wie die horizontale Steifigkeit des Lagers (1) .

5. Lager zur Schwingungsisolation nach einem der vorstehenden Ansprüche, **dadurch gekennzeichnet, dass** zumindest ein Drehgelenk (6, 8), vorzugsweise beide Drehgelenke, in zwei Rotationsfreiheitgraden, welche im Wesentlichen senkrecht zu einer Vertikalachse verlaufen, beweglich sind.

6. Lager zur Schwingungsisolation nach einem der vorstehenden Ansprüche, **dadurch gekennzeichnet, dass** die Drehgelenke (6, 8) oberhalb und unterhalb des Fluidlagers angeordnet sind.

7. Lager zur Schwingungsisolation nach einem der vorstehenden Ansprüche, **dadurch gekennzeichnet, dass** zumindest eines der Drehgelenke, vorzugsweise ein unteres Drehgelenk (8) als Faltenbalg, insbesondere als Metallfaltenbalg ausgebildet ist.

8. Lager zur Schwingungsisolation nach einem der vorstehenden Ansprüche, **dadurch gekennzeichnet, dass** zumindest eines der Drehgelenke (6) als Feder, insbesondere als Metallfeder, ausgebildet ist.

9. Lager zur Schwingungsisolation nach einem der vorstehenden Ansprüche, **dadurch gekennzeichnet, dass** zumindest eines der Drehgelenke als Feder aus einem elastomeren Vollmaterial, insbesondere Gummi ausgebildet ist.

10. Lager zur Schwingungsisolation nach einem der Ansprüche 8 oder 9, **dadurch gekennzeichnet, dass** das Lager eine weitere Feder, insbesondere Blattfeder (10) aufweist, bei welcher die horizontale Steifigkeit höher, insbesondere mindestens 5 mal höher, als vertikale die Steifigkeit ist.

11. Lager zur Schwingungsisolation nach dem vorstehenden Anspruch, **dadurch gekennzeichnet, dass** zumindest die horizontale Steifigkeit der weiteren Feder (10) veränderbar, insbesondere einstellbar, ist.

12. Lager zur Schwingungsisolation nach einem der vorstehenden Ansprüche, **dadurch gekennzeichnet, dass** eine Feder des Lagers, insbesondere mittels einer elastomeren Haut abgedichtet ist.

13. Lager zur Schwingungsisolation nach einem der vorstehenden Ansprüche, **dadurch gekennzeichnet, dass** zumindest ein Gelenk, insbesondere ein unteres Gelenk, zumindest drei auf Biegung belastete Knickpendel (12) umfasst.

14. Lager zur Schwingungsisolation nach einem der vorstehenden Ansprüche, **dadurch gekennzeichnet, dass** das Lager zumindest einen Aktor (22), insbesondere einen Piezo- oder Magnetaktor, zur aktiven Regelung in zumindest einem Freiheitsgrad umfasst.

15. Lager zur Schwingungsisolation nach einem der vorstehenden Ansprüche, **dadurch gekennzeichnet, dass** das Lager zumindest einen Sensor (21) zur Messung von Positionsänderungen zwischen zu isolierender Last (12), Basis (9) und/oder einem Teil des Lagers umfasst.

16. Schwingungsisolationssystem (20), umfassend zumindest ein Lager (1) zur Schwingungsisolation nach einem der vorstehenden Ansprüche.

17. Schwingungsisolationssystem nach dem vorstehenden Anspruch, **dadurch gekennzeichnet, dass** das Schwingungsisolationssystem (20) zumindest einen Sensor (21) zur Erfassung von Positionsänderungen der zu isolierenden Last (7) in zumindest einer Raumrichtung umfasst.

18. Schwingungsisolationssystem nach einem der vorstehenden Ansprüche, **dadurch gekennzeichnet, dass** das Schwingungsisolationssystem (20) eine Regelungseinrichtung (23) zur aktiven Steuerung eines Aktors (22) und/oder des Fluidlagers (2) umfasst.

19. Schwingungsisolationssystem nach einem der vorstehenden Ansprüche, **dadurch gekennzeichnet, dass** das Schwingungsisolationssystem (20) eine Tragfähigkeit von über 300 kg, vorzugsweise über 500 kg und besonders bevorzugt über 5000 kg aufweist.

## Claims

1. Vibration isolation bearing (1), comprising at least one air bearing (2), which is effective in the horizontal and vertical direction, for horizontal and vertical mounting of a load to be isolated,
**characterised in that**
the horizontal stiffness of the air bearing (2) is more than 5 times greater than the vertical stiffness and that the bearing (1) has at least two pivot joints (6, 8) vertically spaced apart from one another, whereby an isolation added to the air bearing (2) is achieved in the horizontal direction.

2. Vibration isolation bearing as claimed in any one of the preceding claims, **characterised in that** at least one pivot joint (6, 8) has spring stiffness.

3. Vibration isolation bearing as claimed in any one of the preceding claims, **characterised in that** the horizontal stiffness of the air bearing (2) is more than 10 and preferably more than 15 times greater than the vertical stiffness.

4. Vibration isolation bearing as claimed in any one of the preceding claims, **characterised in that** the vertical stiffness of the bearing (1) is at least 0.5, preferably 0.7 and particularly preferably 0.9 times as great as the horizontal stiffness of the bearing (1).

5. Vibration isolation bearing as claimed in any one of the preceding claims, **characterised in that** at least one pivot joint (6, 8), preferably both pivot joints, can move in two rotational degrees of freedom which extend substantially perpendicularly to a vertical axis.

6. Vibration isolation bearing as claimed in any one of the preceding claims, **characterised in that** the pivot joints (6, 8) are disposed above and below the fluid bearing.

7. Vibration isolation bearing as claimed in any one of the preceding claims, **characterised in that** at least one of the pivot joints, preferably a lower pivot joint (8), is formed as bellows, in particular as metal bellows.

8. Vibration isolation bearing as claimed in any one of the preceding claims, **characterised in that** at least one of the pivot joints (6) is formed as a spring, in particular as a metal spring.

9. Vibration isolation bearing as claimed in any one of the preceding claims, **characterised in that** at least one of the pivot joints is formed as a spring made from an elastomeric solid material, in particular rubber.

10. Vibration isolation bearing as claimed in any one claims 8 or 9, **characterised in that** the bearing has a further spring, in particular a leaf spring (10), in which the horizontal stiffness is greater, in particular at least 5 times greater, than the vertical stiffness.

11. Vibration isolation bearing as claimed in the preceding claim, **characterised in that** at least the horizontal stiffness of the further spring (10) can be changed, in particular adjusted.

12. Vibration isolation bearing as claimed in any one of the preceding claims, **characterised in that** a spring of the bearing is sealed, in particular by means of an elastomeric skin.

13. Vibration isolation bearing as claimed in any one of the preceding claims, **characterised in that** at least one joint, in particular a lower joint, comprises at least three buckling pendulums (12) subjected to bending load.

14. Vibration isolation bearing as claimed in any one of the preceding claims, **characterised in that** the bearing comprises at least one actuator (22), in particular a piezo actuator or magnetic actuator, for active regulation in at least one degree of freedom.

15. Vibration isolation bearing as claimed in any one of the preceding claims, **characterised in that** the bearing comprises at least one sensor (21) for measuring positional changes between the load (12) to be isolated, the base (9) and/or a part of the bearing.

16. Vibration isolation system (20), comprising at least one vibration isolation bearing (1) as claimed in any one of the preceding claims.

17. Vibration isolation system as claimed in the preceding claim, **characterised in that** the vibration isolation system (20) comprises at least one sensor (21) for detecting positional changes of the load (7) to be isolated in at least one spatial direction.

18. Vibration isolation system as claimed in any one of the preceding claims, **characterised in that** the vibration isolation system (20) comprises a control device (23) for active control of an actuator (22) and/or of the fluid bearing (2).

19. Vibration isolation system as claimed in any one of the preceding claims, **characterised in that** the vibration isolation system (20) has a load-bearing capacity of over 300 kg, preferably over 500 kg and particularly preferably over 5000 kg.

## Revendications

1. Palier (1) pour l'isolation de vibrations, comprenant au moins un palier pneumatique (2) actif en directions horizontale et verticale pour le soutien en directions horizontale et verticale d'une charge à isoler, **caractérisé en ce que** la rigidité horizontale du palier pneumatique (2) est plus de 5 fois supérieure à la rigidité verticale, et **en ce que** ledit palier (1) présente au moins deux articulations (6, 8) verticalement espacées l'une de l'autre, permettant d'obtenir une isolation en direction horizontale ainsi ajoutée au palier pneumatique (2).

2. Palier pour l'isolation de vibrations selon l'une des revendications précédentes, **caractérisé en ce qu'**au moins une articulation (6, 8) a la rigidité d'un ressort.

3. Palier pour l'isolation de vibrations selon l'une des revendications précédentes, **caractérisé en ce que** la rigidité horizontale du palier pneumatique (2) est plus de 10 fois supérieure, et préférentiellement plus de 15 fois supérieure, à la rigidité verticale.

4. Palier pour l'isolation de vibrations selon l'une des revendications précédentes, **caractérisé en ce que** la rigidité verticale du palier (1) est égale à au moins 0,5 fois, avantageusement à 0,7 fois, et préférentiellement à 0,9 fois, la rigidité horizontale du palier (1).

5. Palier pour l'isolation de vibrations selon l'une des revendications précédentes, **caractérisé en ce qu'**au moins une articulation (6, 8), préférentiellement les deux articulations sont mobiles suivant deux degrés de liberté de rotation qui s'étendent sensiblement perpendiculairement à un axe vertical.

6. Palier pour l'isolation de vibrations selon l'une des revendications précédentes, **caractérisé en ce que** les articulations (6, 8) sont disposées au-dessus et en dessous du palier à fluide.

7. Palier pour l'isolation de vibrations selon l'une des revendications précédentes, **caractérisé en ce qu'**au moins une des articulations, préférentiellement une articulation inférieure (8), est réalisée sous forme de soufflet, en particulier de soufflet métallique.

8. Palier pour l'isolation de vibrations selon l'une des revendications précédentes, **caractérisé en ce qu'**au moins une des articulations (6) est réalisée sous forme de ressort, en particulier de ressort métallique.

9. Palier pour l'isolation de vibrations selon l'une des revendications précédentes, **caractérisé en ce qu'**au moins une des articulations est réalisée sous forme de ressort en matériau élastomère massif, en particulier en caoutchouc.

10. Palier pour l'isolation de vibrations selon l'une des revendications 8 ou 9, ledit palier étant **caractérisé en ce qu'**il comprend un autre ressort, en particulier un ressort à lame (10) pour lequel la rigidité horizontale est supérieure à, en particulier supérieure d'au moins 5 fois, la rigidité verticale.

11. Palier pour l'isolation de vibrations selon la revendication précédente, **caractérisé en ce qu'**au moins la rigidité horizontale de l'autre ressort (10) est variable, en particulier réglable.

12. Palier pour l'isolation de vibrations selon l'une des revendications précédentes, **caractérisé en ce qu'**un ressort du palier est étanchéifié en particulier au moyen d'une pellicule élastomère.

13. Palier pour l'isolation de vibrations selon l'une des revendications précédentes, **caractérisé en ce qu'**au moins une articulation, en particulier une articulation inférieure, comporte au moins trois pendules articulés (12) contraints en flexion.

14. Palier pour l'isolation de vibrations selon l'une des revendications précédentes, ledit palier étant **caractérisé en ce qu'**il comporte au moins un actionneur (22), en particulier un actionneur piézo-électrique ou magnétique, pour un réglage actif suivant au moins un degré de liberté.

15. Palier pour l'isolation de vibrations selon l'une des revendications précédentes, ledit palier étant **caractérisé en ce qu'**il comporte au moins un capteur (21) pour la mesure de variations de position entre la charge à isoler (12), la base (9) et/ou une partie du palier.

16. Système d'isolation des vibrations (20) comprenant au moins un palier (1) pour l'isolation de vibrations selon l'une des revendications précédentes.

17. Système d'isolation des vibrations selon la revendication précédente, ledit système d'isolation des vibrations (20) étant **caractérisé en ce qu'**il comporte au moins un capteur (21) pour la détection de variations de position de la charge à isoler (7) dans au moins une direction spatiale.

18. Système d'isolation des vibrations selon l'une des revendications précédentes, ledit système d'isolation des vibrations (20) étant **caractérisé en ce qu'**il comporte un dispositif de réglage (23) pour la commande active d'un actionneur (22) et/ou du palier à fluide (2).

19. Système d'isolation des vibrations selon l'une des revendications précédentes, ledit système d'isolation des vibrations (20) étant **caractérisé en ce qu'**il a une résistance de portée supérieure à 300 kg, avantageusement supérieure à 500 kg et préférentiellement supérieure à 5 000 kg.
